# EUROPEAN PATENT SPECIFICATION

(11) **EP 4 290 274 B1**
(45) Date of publication and mention of the grant of the patent: **30.07.2025**
(21) Application number: 22762525.8
(22) Date of filing: 01.03.2022
(51) Int. Cl.: G01S 13/88, G01S 13/931, G01S 7/02, H05K 7/20, H05K 9/00

(54) **ELECTRONIC APPARATUS, TERMINAL DEVICE, AND RADAR**
ELEKTRONISCHE VORRICHTUNG, ENDGERÄTEVORRICHTUNG UND RADAR
APPAREIL ÉLECTRONIQUE, DISPOSITIF TERMINAL ET RADAR

(30) Priority: 02.03.2021 CN 202120455828 U
(43) Date of publication of application: 13.12.2023
(73) Proprietor: Shenzhen Yinwang Intelligent Technologies Co., Ltd., Shenzhen City, Guangdong 518129 (CN)
(72) Inventor: ZHOU, Qin, Shenzhen, Guangdong 518129 (CN); QIAN, Rui, Shenzhen, Guangdong 518129 (CN)
(74) Representative: Gill Jennings & Every LLP
(86) International application number: PCT/CN2022/078650
(87) International publication number: WO 2022/184061

(56) References cited:
- WO-A1-97/19497
- CN-A- 110 290 632
- CN-U- 209 299 378
- CN-U- 215 813 334
- JP-A- 2012 089 758
- US-A1- 2016 033 621
- US-A1- 2016 353 563
- US-A1- 2017 077 592
- US-B1- 10 575 448
- US-B1- 6 643 137

## Description

### TECHNICAL FIELD

This application relates to the field of electronic technologies, and in particular, to an electronic apparatus, a terminal device, and a radar.

### BACKGROUND

With the development of economy and technologies, autonomous-driving vehicles gradually become a main development trend of the automobile industry. A millimeter-wave radar is a key part of an autonomous-driving vehicle. During actual applications, very high performance is required, and power consumption is increasing continuously. To resolve a heat dissipation problem caused by increasing power consumption, a metal structural part is usually added inside to implement heat dissipation and temperature equalization. However, if the internal metal structural part cannot be reliably and effectively contact with a circuit board, an electrostatic discharge problem occurs between the metal structural part and the circuit board, and electrostatic discharge damages an electronic device on the circuit board. To resolve the foregoing electrostatic discharge problem, a surface-mount technology may need to be introduced to mount a spring to a surface of the circuit board or clamp a structural part, such as a spring, an electrostatic discharge conductive foam, or the like to the metal structural part, so as to absorb a tolerance between the metal structural part and the circuit board and implement reliable contact between the metal structural part and the circuit board. However, this solution usually increases costs, and occupies a layout area of the circuit board, and may even cause structural strength deterioration due to introduction of the structural part. In a scenario of long-term vibration, a risk of structure damage exists.

Exemplary radar device is know from document US2016/033621, wherein document US10575448 relates to electromagnetic shielding and cooling in an electronic apparatus.

### SUMMARY

This application provides an electronic apparatus that implements equipotential bonding between a metal heat dissipation member and a circuit board by integrally molding an electrical connection member on a housing through injection and has high structural strength.

According to a first aspect, this application provides an electronic apparatus. The electronic apparatus includes a housing, a metal heat dissipation member, an electrical connection member, and a circuit board. The metal heat dissipation member and the circuit board are located in the housing, the housing includes a base plate, and the metal heat dissipation member is located between the base plate and the circuit board. The circuit board includes a grounding layer and an electronic device, the electrical connection member is integrally molded into the housing through injection and is fixedly connected to the housing, one end of the electrical connection member is electrically connected to the grounding layer, and the other end of the electrical connection member is electrically connected to the metal heat dissipation member.

In a possible implementation, the electrical connection member includes a first connection sub-member, a second connection sub-member, and a third connection sub-member that are sequentially connected. The second connection sub-member is fixedly connected to the housing, one end that is of the first connection sub-member and that is away from the second connection sub-member is electrically connected to the grounding layer, and the third connection sub-member is electrically connected to the metal heat dissipation member.

In an implementation, only the second connection sub-member of the electrical connection member is directly fixedly connected to the housing. Specifically, the second connection sub-member is integrally molded into the housing through injection, to implement a fixed connection between the electrical connection member and the housing. In some implementations, the second connection sub-member and the third connection sub-member of the electrical connection member may be integrally molded into the housing through injection, but an end portion that is of the third connection sub-member and that is away from the second connection sub-member needs to be exposed, so as to be used to electrically connect to the metal heat dissipation member.

In a possible implementation, an extension direction of the first connection sub-member intersects with the circuit board, a first through-hole is disposed on the circuit board, and the first connection sub-member is inserted into the first through-hole and is connected to the first through-hole, to electrically connect to the grounding layer.

In an implementation, the extension direction of the first connection sub-member is perpendicular to the circuit board. In other words, the first connection sub-member is vertically inserted into the first through-hole of the circuit board. Within a process error range or to adapt to circuit boards of different structures and shapes and electrical connection members of different shapes, in some implementations, an included angle between the extension direction of the first connection sub-member and the circuit board may be smaller than 90° or larger than 90°. In an implementation, the second connection sub-member includes a first sub-portion connected to the first connection sub-member and a second sub-portion connected to the third connection sub-member. The first sub-portion intersects with the second sub-portion, the first sub-portion is parallel to the extension direction of the first connection sub-member, and the second sub-portion is parallel to an extension direction of the third connection sub-member.

In a possible implementation, the housing further includes a fastening portion, the fastening portion is configured to fixedly connect to the second connection sub-member, and at least a portion of the second connection sub-member is located in the fastening portion.

In an implementation, the housing further includes a housing body, and the fastening portion and the housing body are integrally formed. In this implementation, the electronic apparatus further includes a protective cover, the protective cover and the housing body are enclosed to form an accommodation space, and the metal heat dissipation member and the circuit board are located in the accommodation space.

In a possible implementation, the housing further includes the housing body, the housing body includes a first side wall, the fastening portion is disposed on a side that is of the base plate and that faces the circuit board, and the fastening portion is disposed adjacent to the first side wall.

In a possible implementation, the metal heat dissipation member includes a first side edge, the first side edge is disposed adjacent to the first side wall, the first side edge has a first notch, and an orthographic projection of the fastening portion on the base plate is located in an orthographic projection of the first notch on the base plate. The first connection sub-member is connected to the circuit board through the first notch, and the fastening portion abuts against the circuit board through the first notch.

In an implementation, a shape of the orthographic projection of the fastening portion on the base plate is a rectangle, and a shape of the first notch is also a rectangle. In some implementations, the shape of the orthographic projection of the fastening portion on the base plate is a rectangle, and the shape of the first notch may be a square, an ellipse, an irregular shape, or the like, provided that the fastening portion may abut against the circuit board through the first notch.

In an implementation, there are two fastening portions, two electrical connection members, and two first notches, and the two first notches are located on two sides of the first side edge. In some implementations, one of the first notches may be disposed on the first side edge, the other first notch may be disposed on a second side edge of the metal heat dissipation member, and the second side edge is adjacent to the first side edge. In some implementations, one of the first notches may be disposed on the first side edge, the other first notch may be disposed on a third side edge of the metal heat dissipation member, and the third side edge and the first side edge are disposed at an interval.

In a possible implementation, a first through hole that penetrates two opposite surfaces of the metal heat dissipation member is disposed on the metal heat dissipation member, and the orthographic projection of the fastening portion on the base plate is located in an orthographic projection of the first through hole on the base plate.

In some implementations, when there are two fastening portions and two electrical connection members, one of the fastening portions may abut against the circuit board through the first notch, and the other fastening portion may abut against the circuit board through the first through hole.

In a possible implementation, the extension direction of the third connection sub-member intersects with the metal heat dissipation member, a second through hole that penetrates the two opposite surfaces of the metal heat dissipation member is disposed on the metal heat dissipation member, and one end that is of the third connection sub-member and that is away from the second connection sub-member passes through the second through hole and is fixedly connected to the metal heat dissipation member through the second through hole.

In an implementation, the extension direction of the third connection sub-member is perpendicular to the metal heat dissipation member. Within a process error range or to adapt to metal heat dissipation members of different structures and shapes and electrical connection members of different shapes, in some implementations, an included angle between the extension direction of the third connection sub-member and the metal heat dissipation member may be smaller than 90° or larger than 90°.

In a possible implementation, a manner of fixed connection between the third connection sub-member and the metal heat dissipation member is one of interference fit connection, snap connection, or welding.

In a possible implementation, the extension direction of the third connection sub-member is parallel to the metal heat dissipation member, and the third connection sub-member is attached to a surface that is of the metal heat dissipation member and that faces the base plate.

In a possible implementation, a distance from a surface that is of the third connection sub-member and that is away from the base plate to the base plate is longer than a distance from a surface that is of the second sub-portion and that is away from the base plate to the base plate. In other words, compared with the second sub-portion, the third connection sub-member is protruded to the metal heat dissipation member, so that the third connection sub-member is more closely attached to the metal heat dissipation member, thereby improving electrical connectivity.

In a possible implementation, the circuit board includes a signal transmitting unit and a signal receiving unit, the signal transmitting unit is configured to transmit a signal, and the signal receiving unit is configured to receive a signal.

In a possible implementation, the electrical connection member is a fisheye pin. The fisheye pin may be solid or hollow. In this application, a shape of the first connection sub-member in the fisheye pin is not limited.

In a possible implementation, a fastening post is disposed on a surface that is of the base plate and that faces the metal heat dissipation member, a third through hole that penetrates the two opposite surfaces of the metal heat dissipation member is disposed on the metal heat dissipation member, the fastening post passes through the third through hole. After the fastening post is hot pressed, the fastening post is fastened on a surface that is of the metal heat dissipation member and that faces the circuit board.

In a possible implementation, a waterproof and breathable member is disposed on the base plate. The waterproof and breathable member is configured to enable air to flow on two sides of the base plate, so as to dissipate heat inside the housing, avoid thermal expansion and cold contraction, and maintain pressure balance inside the housing.

In a possible implementation, the electronic apparatus further includes a plurality of connecting portions. The connecting portion includes a connector and a connecting line that are connected to each other. The connector is located in the housing, a plurality of second through-holes are disposed on the circuit board, the connector is inserted into the second through-hole and is electrically connected to the second through-hole, and the connecting line passes through a third side wall and is electrically connected to an external electronic device. The connecting portion includes at least one of a voltage line, a signal transmission line, and a ground line.

In a possible implementation, a flanging portion facing the circuit board is disposed around the metal heat dissipation member. The flanging portion is configured to shield interference of an external signal to a signal in the circuit board or prevent a signal in the circuit board from being radiated. A shape of each side edge of the metal heat dissipation member is not limited, and may be specifically set according to an actual requirement.

In a possible implementation, the metal heat dissipation member includes a heat dissipation sub-member protruded toward the circuit board, thermal paste is disposed on a surface that is of the heat dissipation sub-member and that faces the circuit board, and an orthographic projection of the electronic device of the circuit board on the metal heat dissipation member at least partially overlaps with an orthographic projection of the heat dissipation sub-member on the metal heat dissipation member. Thermal paste may accelerate heat dissipation efficiency of the electronic device during working. In this implementation, the orthographic projection of the electronic device on the metal heat dissipation member completely overlaps the orthographic projection of the heat dissipation sub-member on the metal heat dissipation member, so as to improve a heat dissipation capability of the electronic device. A quantity of heat dissipation sub-members and distribution positions of the heat dissipation sub-members may be set based on a quantity of electronic devices and positions of the electronic devices on the circuit board.

According to a second aspect, this application provides a terminal device. The terminal device includes the electronic apparatus according to any one of the foregoing implementations, and the electronic apparatus is fastened to the terminal device.

In a possible implementation, the terminal device is a car, an uncrewed aerial vehicle, or a robot.

According to a third aspect, this application provides a radar, and the radar includes the electronic apparatus according to any one of the foregoing implementations.

In a possible implementation, the radar further includes a signal processing apparatus, and an information processing apparatus is electrically connected to a circuit board.

### BRIEF DESCRIPTION OF DRAWINGS

To describe technical solutions in embodiments of this application more clearly, the following describes accompanying drawings used in embodiments of this application.
FIG. 1 is a schematic three-dimensional exploded view of an electronic apparatus according to an implementation of this application;
FIG. 2 is a schematic diagram of a structure of an electronic apparatus without a circuit board and a protective cover according to an implementation of this application;
FIG. 3 is a schematic diagram of a structure of an electronic apparatus without a protective cover according to an implementation of this application;
FIG. 4 is a schematic diagram of a structure of an electrical connection member in an electronic apparatus according to an implementation of this application;
FIG. 5 is a schematic diagram of a structure of an electrical connection member that is in an electronic apparatus and that is installed on a fastening portion according to an implementation of this application;
FIG. 6 is a schematic diagram of a partial structure of connection between an electrical connection member and a metal heat dissipation member in an electronic apparatus according to an implementation of this application;
FIG. 7 is a schematic diagram of a structure of a metal heat dissipation member in an electronic apparatus according to an implementation of this application;
FIG. 8 is a schematic diagram of a structure of a metal heat dissipation member in an electronic apparatus according to an implementation of this application;
FIG. 9 is a schematic diagram of positions of a metal heat dissipation member and a fastening portion in an electronic apparatus according to an implementation of this application;
FIG. 10 is a schematic diagram of positions of a metal heat dissipation member and a fastening portion in an electronic apparatus according to an implementation of this application;
FIG. 11 is a schematic diagram of a structure of connection between an electrical connection member and a metal heat dissipation member in an electronic apparatus according to an implementation of this application;
FIG. 12 is a schematic diagram of a structure of a circuit board in an electronic apparatus according to an implementation of this application;
FIG. 13 is a schematic three-dimensional exploded view of an electronic apparatus according to an implementation of this application;
FIG. 14 is a schematic diagram of a structure of an electrical connection member that is in an electronic apparatus and that is installed on a fastening portion according to an implementation of this application;
FIG. 15 is a schematic diagram of a structure of an electrical connection member in an electronic apparatus according to an implementation of this application; and
FIG. 16 is a schematic diagram of a structure of a terminal device according to an implementation of this application.

### DESCRIPTION OF EMBODIMENTS

The following describes technical solutions in embodiments of this application with reference to accompanying drawings in embodiments of this application. It is clearly that the described embodiments are merely some instead of all of embodiments of this application.

Terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In descriptions of this application, unless otherwise stated, "a plurality of" means two or more than two.

In addition, in this specification, position terms such as "top" and "bottom" are defined relative to positions of structures in the accompanying drawings. It should be understood that these position terms are relative concepts used for relative description and clarification, and may correspondingly change based on changes in the positions of the structures.

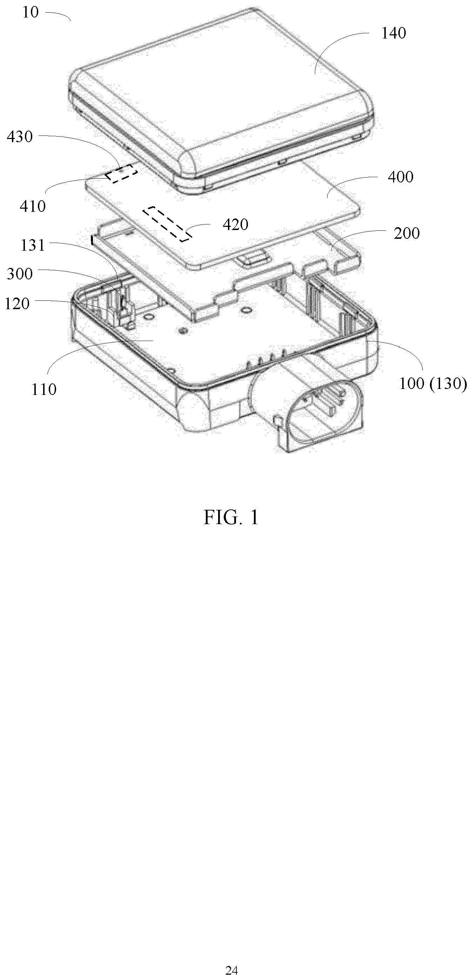

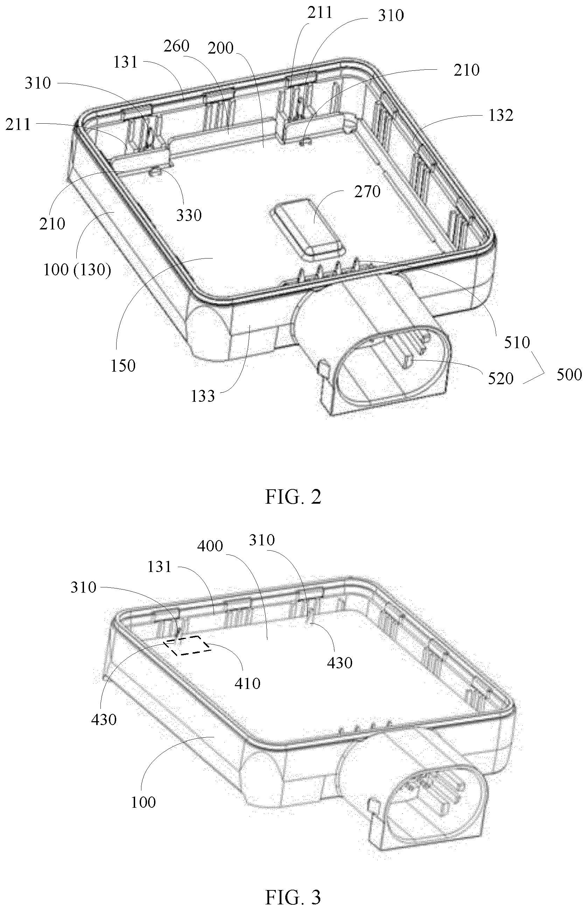

Refer to FIG. 1 to FIG. 3. An embodiment of this application provides an electronic apparatus 10, including a housing 100, a metal heat dissipation member 200, an electrical connection member 300, and a circuit board 400. The metal heat dissipation member 200 and the circuit board 400 are located in the housing 100 (as shown in FIG. 2 and FIG. 3). The housing 100 includes a base plate 110, and the metal heat dissipation member 200 is located between the base plate 110 and the circuit board 400. The circuit board 400 includes a grounding layer 410 and an electronic device 420. The electrical connection member 300 is integrally molded into the housing 100 through injection and is fixedly connected to the housing 100, one end of the electrical connection member 300 is electrically connected to the grounding layer 410, and the other end of the electrical connection member 300 is electrically connected to the metal heat dissipation member 200.

The housing 100 is a housing having an accommodation space, and the metal heat dissipation member 200 and the circuit board 400 may be accommodated in the housing 100. The circuit board 400 further includes a substrate, the electronic device 420 may be located on a surface of the substrate or may be located in the substrate. The electronic device 420 may be configured to implement a specific function. Specifically, the electronic device 420 with a specific function may be disposed in the circuit board 400 according to an actual requirement. The metal heat dissipation member 200 is configured to dissipate heat. When the circuit board 400 works, the electronic device 420 generates heat. The metal heat dissipation member 200 is configured to transfer heat generated by the circuit board 400 to the outside, so as to prevent excessively high temperature of the electronic device 420 from affecting working performance.

Two ends of the electrical connection member 300 are electrically connected to the grounding layer 410 and the metal heat dissipation member 200 respectively, so that potentials of the grounding layer 410 and the metal heat dissipation member 200 are equal. This prevents electrostatic discharge between the metal heat dissipation member 200 and the circuit board 400 from damaging the electronic device 420 on the circuit board 400. Compared with a prior-art manner in which a structural part such as a spring or a conductive foam is mounted to a surface of the circuit board 400 to enable the circuit board 400 to be attached to the metal heat dissipation member 200, so as to eliminate electrostatic discharge, a manner in which the electrical connection member 300 is electrically connected to the grounding layer 410 of the circuit board 400 and the metal heat dissipation member 200 may reduce structural part costs, may reduce occupied space in the housing 100, and do not occupy a layout area of the electronic device 420 on the circuit board 400.

Integral molding of the electrical connection member 300 into the housing 100 through injection means that when the housing 100 is formed, the electrical connection member 300 and a fused material for forming the housing 100 are placed into a mold for the housing 100, and the housing 100 and the electrical connection member 300 are integrally molded through injection, and the electrical connection member 300 is fastened to the housing 100. One end of the electrical connection member 300 is electrically connected to the grounding layer 410 of the circuit board 400, so that the circuit board 400 is fastened to one end of the electrical connection member 300, and then the circuit board 400, the electrical connection member 300, and the housing 100 are fastened. In addition, the metal heat dissipation member 200 is disposed between the base plate 110 and the circuit board 400, and the metal heat dissipation member 200 may be press-fitted and fastened between the circuit board 400 and the base plate 110 by using the circuit board 400, so that the circuit board 400 and the metal heat dissipation member 200 are simultaneously fastened in the housing 100. Compared with the prior-art manner in which a structural part such as a spring or a conductive foam is mounted to a surface of the circuit board 400 to enable the circuit board 400 to be attached to the metal heat dissipation member 200, so as to eliminate electrostatic discharge, a manner in which the electrical connection member 300 is integrally molded into the housing 100 through injection and the electrical connection member 300 is electrically connected to the grounding layer 410 of the circuit board 400 and the metal heat dissipation member 200 may enable the electronic apparatus 10 to have higher structural strength, enable the electronic apparatus 10 to have higher structure reliability in a long-term vibration scenario, and prevent the electronic apparatus 10 being damaged.

In the electronic apparatus 10 provided in this application, the electrical connection member 300 is integrally molded into the housing 100 through injection, and the electrical connection member 300 is electrically connected to the grounding layer 410 of the circuit board 400 and the metal heat dissipation member 200. An electrostatic discharge phenomenon between the metal heat dissipation member 200 and the circuit board 400 may be eliminated, thereby preventing electrostatic discharge from damaging the electronic device 420 on the circuit board 400. In addition, the circuit board 400 is fastened to the housing 100 by using the electrical connection member 300, and the metal heat dissipation member 200 is fastened between the circuit board 400 and the base plate 110, thereby improving structural strength of the electronic apparatus 10.

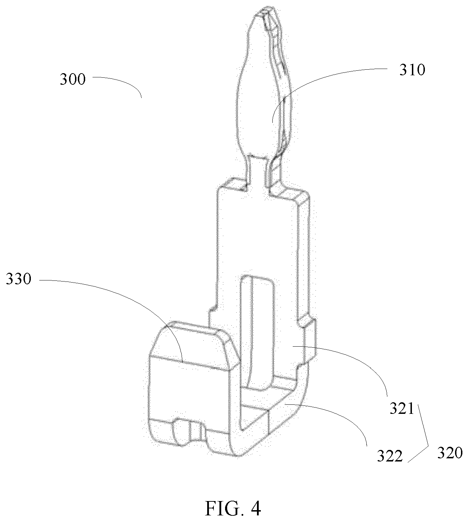

Refer to FIG. 4. In a possible implementation, the electrical connection member 300 includes a first connection sub-member 310, a second connection sub-member 320, and a third connection sub-member 330 that are sequentially connected. The second connection sub-member 320 is fixedly connected to the housing 100. One end that is of the first connection sub-member 310 and that is away from the second connection sub-member 320 is electrically connected to the grounding layer 410 (as shown in FIG. 3), and the third connection sub-member 330 is electrically connected to the metal heat dissipation member 200 (as shown in FIG. 2). In this implementation, only the second connection sub-member 320 of the electrical connection member 300 is directly fixedly connected to the housing 100. Specifically, the second connection sub-member 320 is integrally molded into the housing 100 through injection to implement a fixed connection between the electrical connection member 300 and the housing 100. In some implementations, the second connection sub-member 320 and the third connection sub-member 330 of the electrical connection member 300 may be integrally molded into the housing 100 through injection, but an end portion that is of the third connection sub-member 330 and that is away from the second connection sub-member 320 needs to be exposed, so as to be used to electrically connect to the metal heat dissipation member 200. In this implementation, the electrical connection member 300 is a fisheye pin. The fisheye pin may be solid or hollow. In this application, a shape of the first connection sub-member 310 in the fisheye pin is not limited.

In a possible implementation, an extension direction of the first connection sub-member 310 intersects with the circuit board 400, a first through-hole 430 (as shown in FIG. 1 and FIG. 3) is disposed on the circuit board 400, and the first connection sub-member 310 is inserted into the first through-hole 430 and is connected to the first through-hole 430, to electrically connect to the grounding layer 410. Intersection between the extension direction of the first connection sub-member 310 and the circuit board 400 means that the extension direction of the first connection sub-member 310 intersects with an entire board surface of the circuit board 400. In this implementation, the extension direction of the first connection sub-member 310 is perpendicular to the circuit board 400. In other words, the first connection sub-member 310 is vertically inserted into the first through-hole 430 of the circuit board 400. Within a process error range or to adapt to circuit boards 400 of different structures and shapes and electrical connection members 300 of different shapes, in some implementations, an included angle between the extension direction of the first connection sub-member 310 and the circuit board 400 may be smaller than 90° or larger than 90°. In this implementation, the second connection sub-member 320 includes a first sub-portion 321 connected to the first connection sub-member 310 and a second sub-portion 322 connected to the third connection sub-member 330 (as shown in FIG. 4). The first sub-portion 321 intersects with the second sub-portion 322, the first sub-portion 321 is parallel to the extension direction of the first connection sub-member 310, and the second sub-portion 322 is parallel to an extension direction of the third connection sub-member 330.

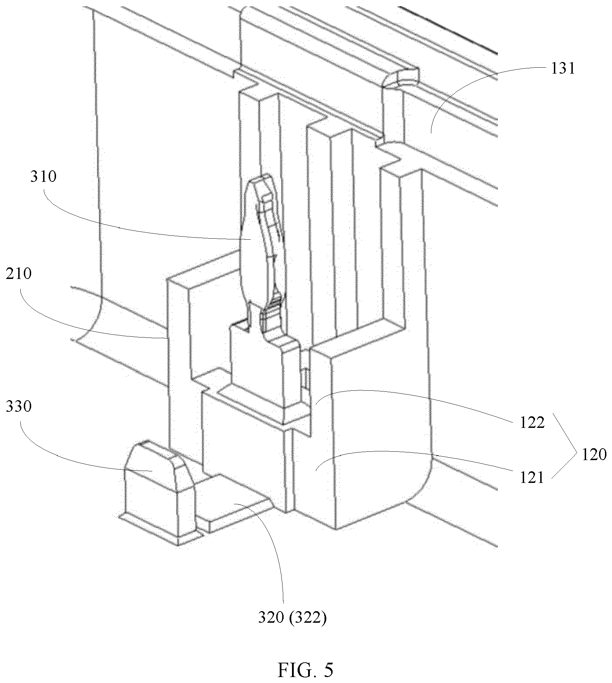

Refer to FIG. 5. In a possible implementation, the housing 100 further includes a fastening portion 120, the fastening portion 120 is configured to fixedly connect to the second connection sub-member 320, and at least a portion of the second connection sub-member 320 is located in the fastening portion 120. The fastening portion 120 may be any portion of the housing 100, and the second connection sub-member 320 may be fastened to any position of the housing 100 according to an actual requirement. In this implementation, the housing 100 further includes a housing body 130 (as shown in FIG. 1), and the fastening portion 120 and the housing body 130 are integrally molded. In this implementation, the electronic apparatus 10 further includes a protective cover 140, the protective cover 140 and the housing body 130 are enclosed to form an accommodation space 150, and the metal heat dissipation member 200 and the circuit board 400 are located in the accommodation space 150. The fastening portion 120 is configured to fixedly connect to the second connection sub-member 320. When the electrical connection member 300 and the housing 100 are integrally molded through injection, an injection mold of the housing 100 may be disposed as a shape of the fastening portion 120 according to a requirement, and the second connection sub-member 320 of the electrical connection member 300 is placed at a position that is of the injection mold and that has the shape of the fastening portion 120. After integral injection molding is completed, a structure in which the fastening portion 120 is fixedly connected to the second connection sub-member 320 may be obtained. In this implementation, the first sub-portion 321 of the second connection sub-member 320 is located in the fastening portion 120.

A specific shape of the fastening portion 120 is not limited, and may be set according to an actual requirement. In an implementation, the fastening portion 120 includes a fastening portion body 121 and a supporting portion 122 located on the side that is of the fastening portion body 121 and that is away from the base plate 110. The supporting portion 122 is configured to support the circuit board 400, so as to prevent the circuit board 400 from swaying in a direction perpendicular to the circuit board 400. In this implementation, there are two supporting portions 122, which are symmetrically disposed on the fastening portion body 121. In some implementation, the supporting portion 122 may not be disposed for the fastening portion 120, and a surface that is of the fastening portion body 121 and that is away from the base plate 110 may be directly used as a supporting surface to support the circuit board 400.

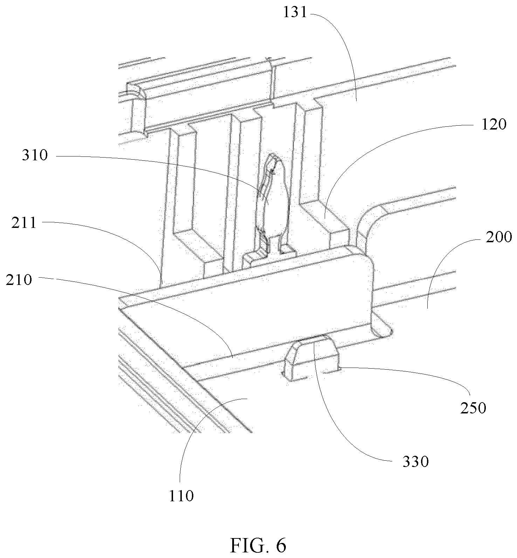

In a possible implementation, the housing body 130 includes a first side wall 131, the fastening portion 120 is located on a side that is of the base plate 110 and that faces the circuit board 400, and the fastening portion 120 is disposed adjacent to the first side wall 131 (as shown in FIG. 6). Refer to FIG. 2 again. In this implementation, the housing body 130 includes the base plate 110, the first side wall 131, a second side wall 132, a third side wall 133, and a fourth side wall 134. The first side wall 131, the second side wall 132, the third side wall 133, and the fourth side wall 134 are sequentially connected. The fastening portion 120 is disposed close to the first side wall 131, and the electrical connection member 300 is electrically connected to an edge position that is of the circuit board 400 and that is adjacent to the first side wall 131 and an edge position that is of the metal heat dissipation member 200 and that is adjacent to the first side wall 131. In other words, the fastening portion 120 and the electrical connection member 300 are located at edge positions of the accommodation space 150. Disposing the fastening portion 120 and the electrical connection member 300 at edge positions of the accommodation space 150 may reduce occupied space in the middle portion of the housing 100.

In a possible implementation, the metal heat dissipation member 200 includes a first side edge 210 (as shown in FIG. 6), the first side edge 210 is disposed adjacent to the first side wall 131, the first side edge 210 has a first notch 211, and an orthographic projection of the fastening portion 120 on the base plate 110 is located in an orthographic projection of the first notch 211 on the base plate 110. The first connection sub-member 310 is connected to the circuit board 400 through the first notch 211, and the fastening portion 120 abuts against the circuit board 400 through the first notch 211. The first notch 211 is disposed to avoid the fastening portion 120, and a shape of the first notch 211 may be set based on a shape of the fastening portion 120, so as to ensure that the metal heat dissipation member 200 can be attached to the base plate 110 to a maximum extent, and reduce an interstice between the metal heat dissipation member 200 and the base plate 110. In this implementation, a shape of the orthographic projection of the fastening portion 120 on the base plate 110 is a rectangle, and the shape of the first notch 211 is also a rectangle. In some implementations, the shape of the orthographic projection of the fastening portion 120 on the base plate 110 is a rectangle, and the shape of the first notch 211 may be a square, an ellipse, an irregular shape, or the like, provided that the fastening portion 120 may abut against the circuit board 400 through the first notch 211.

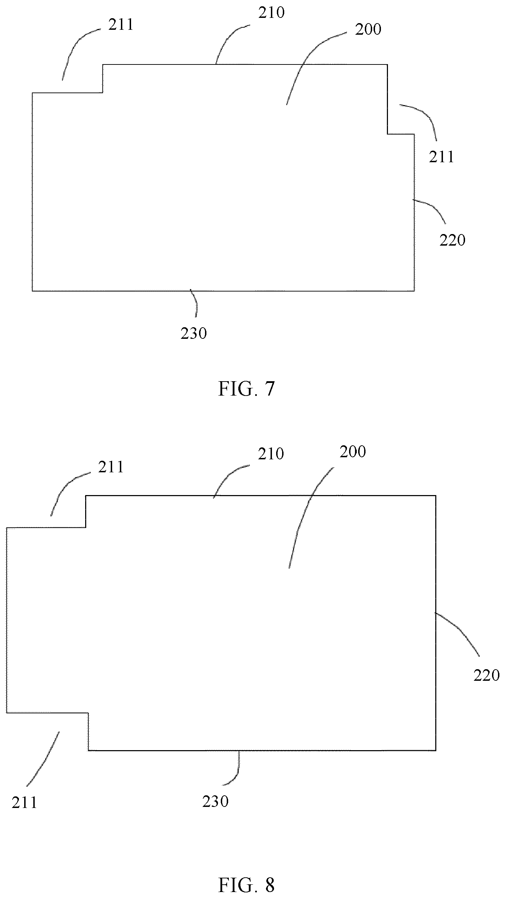

In the foregoing implementation, there are two fastening portions 120, two electrical connection members 300, and two first notches 211, and the two first notches 211 are located on two sides of the first side edge 210 (as shown in FIG. 2). Refer to FIG. 7. In some implementations, one of the first notches 211 may be disposed on the first side edge 210, the other first notch 211 may be disposed on a second side edge 220 of the metal heat dissipation member 200, and the second side edge 220 is adjacent to the first side edge 210. Refer to FIG. 8. In some implementations, one of the first notches 211 may be disposed on the first side edge 210, the other first notch 211 may be disposed on a third side edge 230 of the metal heat dissipation member 200, and the third side edge 230 and the first side edge 210 are disposed at an interval. In this application, a quantity of first notches 211 may be set based on a quantity of electrical connection members 300 and a quantity of fastening portions 120, and a specific position may be set based on specific structures of the housing 100 and the metal heat dissipation member 200.

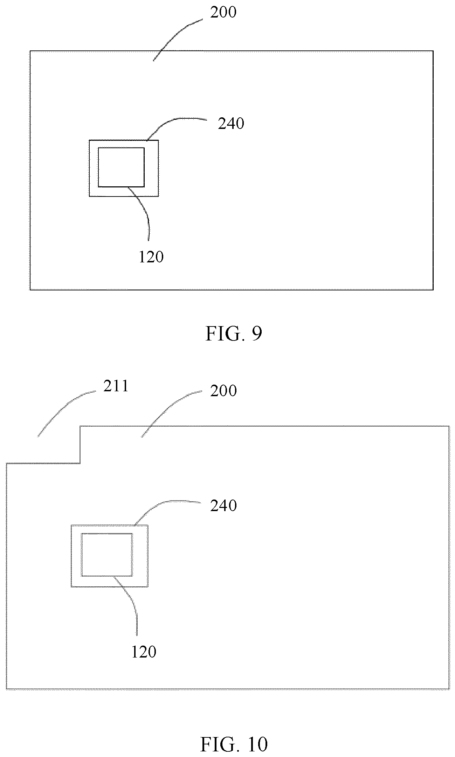

Refer to FIG. 9. In a possible implementation, a first through hole 240 that penetrates two opposite surfaces of the metal heat dissipation member 200 is disposed on the metal heat dissipation member 200, and the orthographic projection of the fastening portion 120 on the base plate 110 is located in an orthographic projection of the first through hole 240 on the base plate 110. The first through hole 240 is located in the metal heat dissipation member 200. In this implementation, the fastening portion 120 abuts against the circuit board 400 after passing through the first through hole 240. A position of the first through hole 240 may be set at any position in the metal heat dissipation member 200. When there are two fastening portions 120, two electrical connection members 300, and two first through holes 240, the two first through holes 240 may be symmetrically or asymmetrically disposed in the metal heat dissipation member 200.

Refer to FIG. 10. In some implementations, when there are two fastening portions 120 and two electrical connection members 300, one of the fastening portions 120 may abut against the circuit board 400 through the first notch 211, and the other fastening portion 120 may abut against the circuit board 400 through the first through hole 240.

Refer to FIG. 6 again. In a possible implementation, the extension direction of the third connection sub-member 330 intersects with the metal heat dissipation member 200, a second through hole 250 that penetrates the two opposite surfaces of the metal heat dissipation member 200 is disposed on the metal heat dissipation member 200, and one end that is of the third connection sub-member 330 and that is away from the second connection sub-member 320 passes through the second through hole 250 and is fixedly connected to the metal heat dissipation member 200 through the second through hole 250. In this implementation, the extension direction of the third connection sub-member 330 is perpendicular to the metal heat dissipation member 200. Within a process error range or to adapt to metal heat dissipation members 200 of different structures and shapes and electrical connection members 300 of different shapes, in some implementations, an included angle between the extension direction of the third connection sub-member 330 and the metal heat dissipation member 200 may be smaller than 90° or larger than 90°. The metal heat dissipation member 200 is disposed in approximately parallel to the entire board surface of the circuit board 400. In this implementation, the extension direction of the third connection sub-member 330 is parallel to the extension direction of the first connection sub-member 310, and both are perpendicular to the second connection sub-member 320. When there are a plurality of electrical connection members 300, there are also a plurality of second through holes 250. A quantity of second through holes 250 are the same as a quantity of electrical connection members 300. In this implementation, there are two electrical connection members 300 and two second through holes 250.

In this implementation, the second through hole 250 is disposed adjacent to the fastening portion 120. In this case, the third connection sub-member 330 does not need to be excessively long, so as to save costs. In some implementations, the second through hole 250 may be disposed away from the fastening portion 120, or a distance between the second through hole 250 and the fastening portion 120 may be set according to an actual requirement.

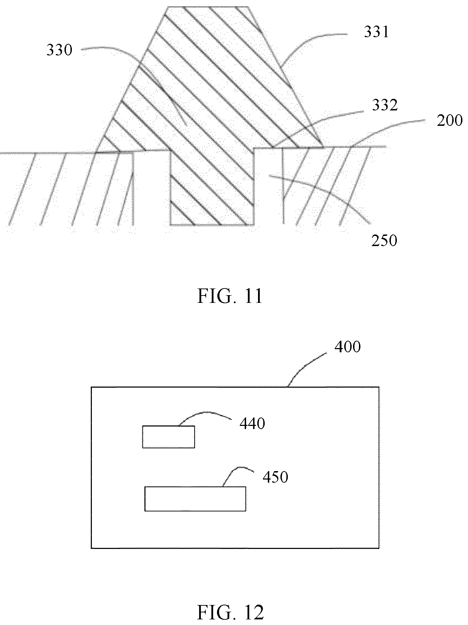

In a possible implementation, a manner of fixed connection between the third connection sub-member 330 and the metal heat dissipation member 200 is one of interference fit connection, snap connection, or welding. The interference fit connection means that the third connection sub-member 330 has specific elasticity, and the third connection sub-member 300 is squeezed into the second through hole 250 and is fixedly connected to the second through hole 250. One manner of the snap connection is that a guiding portion 331 and a step portion 332 (as shown in FIG. 11) are disposed at an end portion of the third connection sub-member 330, and after the guiding portion 331 passes through the second through hole 250, the step portion 332 abuts against the metal heat dissipation member 200 around the second through hole 250, so that the connection between the metal heat dissipation member 200 and the third connection sub-member 330 is fastened. Welding means that the third connection sub-member 330 is welded to a portion of the metal heat dissipation member 200 around the second through hole 250.

In a possible implementation, a fastening post is disposed on a surface that is of the base plate 110 and that faces the metal heat dissipation member 200, a third through hole that penetrates two opposite surfaces of the metal heat dissipation member 200 is disposed on the metal heat dissipation member 200, the fastening post passes through the third through hole. After the fastening post is hot pressed, the fastening post is fastened on a surface that is of the metal heat dissipation member 200 and that faces the circuit board 400.

In a possible implementation, a waterproof and breathable member is disposed on the base plate 110. The waterproof and breathable member is configured to enable air to flow on two sides of the base plate 110, so as to dissipate heat inside the housing 100, avoid thermal expansion and cold contraction, and maintain pressure balance inside the housing 100.

In a possible implementation, a flanging portion 260 (as shown in FIG. 2) facing the circuit board 400 is disposed around the metal heat dissipation member 200. The flanging portion 260 is configured to shield interference of an external signal to a signal in the circuit board 400 or prevent a signal in the circuit board 400 from being radiated. A shape of each side edge of the metal heat dissipation member 200 is not limited, and may be specifically set according to an actual requirement.

In a possible implementation, the metal heat dissipation member 200 includes a heat dissipation sub-member 270 protruded toward the circuit board 400, thermal paste is disposed on a surface that is of the heat dissipation sub-member 270 and that faces the circuit board 400, and an orthographic projection of the electronic device 420 of the circuit board 400 on the metal heat dissipation member 200 at least partially overlaps with an orthographic projection of the heat dissipation sub-member 270 on the metal heat dissipation member 200. Thermal paste may accelerate heat dissipation efficiency of the electronic device 420 during working. In this implementation, the orthographic projection of the electronic device 420 on the metal heat dissipation member 200 completely overlaps the orthographic projection of the heat dissipation sub-member 270 on the metal heat dissipation member 200, so as to improve a heat dissipation capability of the electronic device 420. A quantity of heat dissipation sub-members 270 and distribution positions of the heat dissipation sub-members 270 may be set based on a quantity of electronic devices 420 and positions of the electronic devices 420 on the circuit board 400.

In a possible implementation, the electronic apparatus 10 further includes a plurality of connecting portions 500. The connecting portion 500 includes a connector 510 and a connecting line 520 (as shown in FIG. 2) that are connected to each other. The connector 510 is located in the housing 100, a plurality of second through-holes are disposed on the circuit board 400, the connector 510 is inserted into the second through-hole and is electrically connected to the second through-hole, and the connecting line 520 passes through the third side wall 133 and is electrically connected to an external electronic device. The connecting portion includes at least one of a voltage line, a signal transmission line, and a ground line.

Refer to FIG. 12. In a possible implementation, the circuit board 400 includes a signal transmitting unit 440 and a signal receiving unit 450. The signal transmitting unit 440 is configured to transmit a signal, and the signal receiving unit 450 is configured to receive a signal. In this implementation, the electronic apparatus 10 may be configured to receive a signal and transmit a signal, and may be specifically a radar.

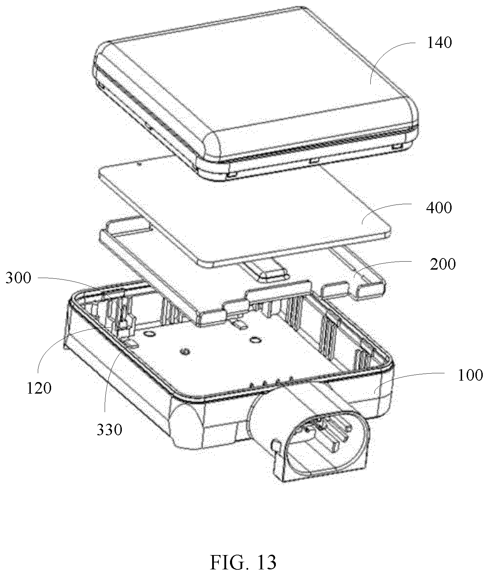

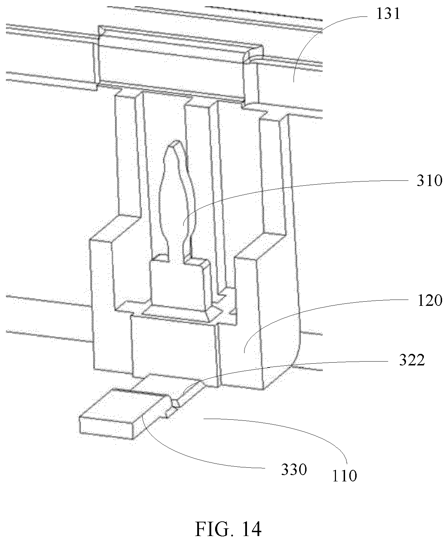

Refer to FIG. 13, FIG. 14, and FIG. 15. In a possible implementation, the extension direction of the third connection sub-member 330 is parallel to the metal heat dissipation member 200, and the third connection sub-member 330 is attached to a surface that is of the metal heat dissipation member 200 and that faces the base plate 110. In this implementation, the third connection sub-member 330 is in a plate shape and has a surface that is attached to the metal heat dissipation member 200. Attaching means that after the third connection sub-member 330 is attached to the metal heat dissipation member 200, at least an electrical connection between the third connection sub-member 330 and the metal heat dissipation member 200 can be implemented. In this manner, the second through hole 250 does not need to be disposed in the metal heat dissipation member 200, thereby reducing a process. In this implementation, the third connection sub-member 330 includes a flat plate, and a shape of the third connection sub-member 330 is not limited to a rectangle, a square, an ellipse, a circle, or the like. In some implementations, the third connection sub-member 330 may alternatively include at least two flat plates.

In a possible implementation, a distance from a surface that is of the third connection sub-member 330 and that is away from the base plate 110 to the base plate 110 is longer than a distance from a surface that is of the second sub-portion 322 and that is away from the base plate 110 to the base plate (as shown in FIG. 13). In other words, compared with the second sub-portion 322, the third connection sub-member 330 is protruded to the metal heat dissipation member 200, so that the third connection sub-member 330 is more closely attached to the metal heat dissipation member 200, thereby improving electrical connectivity.

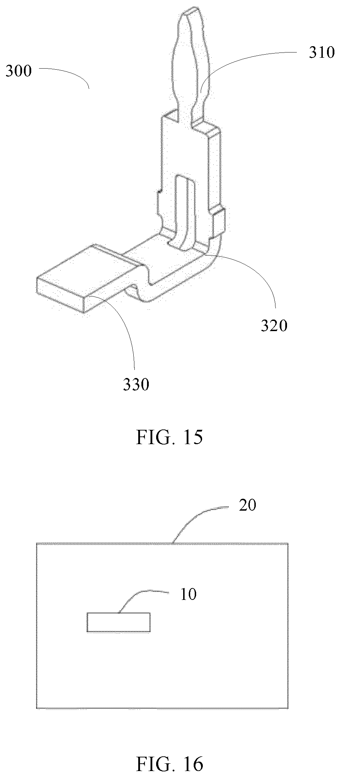

Refer to FIG. 16, an implementation of this application provides a terminal device 20. The terminal device 20 includes the electronic apparatus 10 in any one of the foregoing implementations, and the electronic apparatus 10 is fastened to the terminal device 20. The terminal device 20 may be a car, an uncrewed aerial vehicle, a robot, a yacht, or the like. In some implementations, the terminal device 20 may be a computer product or a communication product, for example, a computer, or a home appliance product having a communication function, for example, a refrigerator or a washing machine. In an implementation, a mounting portion is disposed outside the housing 100, and is configured to mount the electronic apparatus 10 onto the terminal device 20.

An implementation of this application provides a radar, and the radar includes the electronic apparatus 10 in any one of the foregoing implementations.

In an implementation, the radar further includes a signal processing apparatus, and the signal processing apparatus is electrically connected to a circuit board 400 in the electronic apparatus 10. In this implementation, the circuit board 400 is provided with a signal transmitting unit 440 and a signal receiving unit 450. The signal processing apparatus is configured to transmit a processed signal to the signal transmitting unit 440 for transmission, or the signal receiving unit 450 transmits a received signal to the signal processing apparatus for processing. The signal processing apparatus may be a mobile data center (Mobile Data Center, MDC).

In some implementations, a signal processor may be disposed on the circuit board 400 in the radar and is configured to process a signal.

In an implementation, when the signal transmitting unit 440 and the signal receiving unit 450 are not disposed on the circuit board 400, the radar further includes a signal transceiver, and the signal transceiver is configured to transmit a signal and receive a signal.

The electronic apparatus, terminal device, and radar provided in embodiments of this application are described in detail above. The principles and embodiments of this application are described by using specific examples in this specification. Descriptions about the foregoing embodiments are merely provided to help understand the method and core ideas of this application. In addition, a person of ordinary skill in the art can make variations and modifications in terms of the specific embodiments and application scopes according to the ideas of this application, as long as said variations and modifications fall within the scope of the invention, which is defined by the appended claims.

## Claims

1. An electronic apparatus, wherein the electronic apparatus comprises a housing (100), a metal heat dissipation member (200), an electrical connection member (300), and a circuit board (400), the metal heat dissipation member (200) and the circuit board (400) are located in the housing (100), the housing (100) comprises a base plate (110), and the metal heat dissipation member (200) is located between the base plate (110) and the circuit board (400); and the circuit board (400) comprises a grounding layer (410) and an electronic device (420), one end of the electrical connection member (300) is electrically connected to the grounding layer (410), and the other end of the electrical connection member (300) is electrically connected to the metal heat dissipation member (200), **characterized in that** the electrical connection member (300) is integrally molded into the housing (100) through injection and is fixedly connected to the housing (100).

2. The electronic apparatus according to claim 1, wherein the electrical connection member comprises a first connection sub-member, a second connection sub-member, and a third connection sub-member that are sequentially connected, the second connection sub-member is fixedly connected to the housing, one end that is of the first connection sub-member and that is away from the second connection sub-member is electrically connected to the grounding layer, and the third connection sub-member is electrically connected to the metal heat dissipation member.

3. The electronic apparatus according to claim 2, wherein an extension direction of the first connection sub-member intersects with the circuit board, a first through-hole is disposed on the circuit board, and the first connection sub-member is inserted into the first through-hole and is connected to the first through-hole, to electrically connect to the grounding layer.

4. The electronic apparatus according to claim 2, wherein the housing further comprises a fastening portion, the fastening portion is configured to fixedly connect to the second connection sub-member, and at least a portion of the second connection sub-member is located in the fastening portion.

5. The electronic apparatus according to claim 4, wherein the housing further comprises a housing body, the housing body comprises a first side wall, the fastening portion is disposed on a side that is of the base plate and that faces the circuit board, and the fastening portion is disposed adjacent to the first side wall.

6. The electronic apparatus according to claim 5, wherein the metal heat dissipation member comprises a first side edge, the first side edge is disposed adjacent to the first side wall, the first side edge has a first notch, an orthographic projection of the fastening portion on the base plate is located in an orthographic projection of the first notch on the base plate, the first connection sub-member is connected to the circuit board through the first notch, and the fastening portion abuts against the circuit board through the first notch.

7. The electronic apparatus according to claim 4, wherein a first through hole that penetrates two opposite surfaces of the metal heat dissipation member is disposed on the metal heat dissipation member, and the orthographic projection of the fastening portion on the base plate is located in an orthographic projection of the first through hole on the base plate.

8. The electronic apparatus according to any one of claims 3 to 7, wherein an extension direction of the third connection sub-member intersects with the metal heat dissipation member, a second through hole that penetrates the two opposite surfaces of the metal heat dissipation member is disposed on the metal heat dissipation member, and one end that is of the third connection sub-member and that is away from the second connection sub-member passes through the second through hole and is fixedly connected to the metal heat dissipation member through the second through hole.

9. The electronic apparatus according to claim 8, wherein a manner of fixed connection between the third connection sub-member and the metal heat dissipation member is one of interference fit connection, snap connection, or welding.

10. The electronic apparatus according to any one of claims 3 to 7, wherein the extension direction of the third connection sub-member is parallel to the metal heat dissipation member, and the third connection sub-member is attached to a surface that is of the metal heat dissipation member and that faces the base plate.

11. The electronic apparatus according to claim 1, wherein the circuit board comprises a signal transmitting unit and a signal receiving unit, the signal transmitting unit is configured to transmit a signal, and the signal receiving unit is configured to receive a signal.

12. The electronic apparatus according to claim 1, wherein the electrical connection member is a fisheye pin.

13. A terminal device, wherein the terminal device comprises the electronic apparatus according to any one of claims 1 to 12, and the electronic apparatus is fastened to the terminal device.

14. The terminal device according to claim 13, wherein the terminal device is a car, an uncrewed aerial vehicle, or a robot.

15. A radar, wherein the radar comprises the electronic apparatus according to any one of claims 1 to 12.

## Patentansprüche

1. Elektronische Vorrichtung, wobei die elektronische Vorrichtung ein Gehäuse (100), ein metallisches Wärmeableitungselement (200), ein elektrisches Verbindungselement (300) und eine Leiterplatte (400) umfasst, sich das metallische Wärmeableitungselement (200) und die Leiterplatte (400) in dem Gehäuse (100) befinden, das Gehäuse (100) eine Grundplatte (110) umfasst und sich das metallische Wärmeableitungselement (200) zwischen der Grundplatte (110) und der Leiterplatte (400) befindet; und die Leiterplatte (400) eine Erdungsschicht (410) und ein elektronisches Gerät (420) umfasst, ein Ende des elektrischen Verbindungselements (300) elektrisch mit der Erdungsschicht (410) verbunden ist und das andere Ende des elektrischen Verbindungselements (300) elektrisch mit dem metallischen Wärmeableitungselement (200) verbunden ist, **dadurch gekennzeichnet, dass** das elektrische Verbindungselement (300) durch Spritzgießen integral in das Gehäuse (100) eingeformt und fest mit dem Gehäuse (100) verbunden ist.

2. Elektronische Vorrichtung nach Anspruch 1, wobei das elektrische Verbindungselement ein erstes Verbindungsunterelement, ein zweites Verbindungsunterelement und ein drittes Verbindungsunterelement umfasst, die aufeinanderfolgend verbunden sind, wobei das zweite Verbindungsunterelement fest mit dem Gehäuse verbunden ist, ein Ende des ersten Verbindungsunterelements, das von dem zweiten Verbindungsunterelement entfernt ist, elektrisch mit der Erdungsschicht verbunden ist und das dritte Verbindungsunterelement elektrisch mit dem metallischen Wärmeableitungselement verbunden ist.

3. Elektronische Vorrichtung nach Anspruch 2, wobei eine Erstreckungsrichtung des ersten Verbindungsunterelements die Leiterplatte kreuzt, ein erstes Durchgangsloch auf der Leiterplatte angeordnet ist und das erste Verbindungsunterelement in das erste Durchgangsloch eingeführt und mit dem ersten Durchgangsloch verbunden ist, um die Erdungsschicht elektrisch zu verbinden.

4. Elektronische Vorrichtung nach Anspruch 2, wobei das Gehäuse ferner einen Befestigungsabschnitt umfasst, der Befestigungsabschnitt dazu konfiguriert ist, fest mit dem zweiten Verbindungsunterelement verbunden zu sein und sich mindestens ein Abschnitt des zweiten Verbindungsunterelements in dem Befestigungsabschnitt befindet.

5. Elektronische Vorrichtung nach Anspruch 4, wobei das Gehäuse ferner einen Gehäusekörper umfasst, der Gehäusekörper eine erste Seitenwand umfasst, der Befestigungsabschnitt auf einer Seite der Grundplatte angeordnet ist, die der Leiterplatte zugewandt ist, und der Befestigungsabschnitt benachbart zu der ersten Seitenwand angeordnet ist.

6. Elektronische Vorrichtung nach Anspruch 5, wobei das metallische Wärmeableitungselement eine erste Seitenkante umfasst, die erste Seitenkante benachbart zu der ersten Seitenwand angeordnet ist, die erste Seitenkante eine erste Kerbe aufweist, sich eine orthographische Projektion des Befestigungsabschnitts auf der Grundplatte in einer orthographischen Projektion der ersten Kerbe auf der Grundplatte befindet, das erste Verbindungsunterelement durch die erste Kerbe mit der Leiterplatte verbunden ist und der Befestigungsabschnitt durch die erste Kerbe an der Leiterplatte anliegt.

7. Elektronische Vorrichtung nach Anspruch 4, wobei ein erstes Durchgangsloch, das zwei gegenüberliegende Oberflächen des metallischen Wärmeableitungselements durchdringt, auf dem metallischen Wärmeableitungselement angeordnet ist und sich die orthographische Projektion des Befestigungsabschnitts auf der Grundplatte in einer orthographischen Projektion des ersten Durchgangslochs auf der Grundplatte befindet.

8. Elektronische Vorrichtung nach einem der Ansprüche 3 bis 7, wobei eine Erstreckungsrichtung des dritten Verbindungsunterelements das metallische Wärmeableitungselement kreuzt, ein zweites Durchgangsloch, das die beiden gegenüberliegenden Oberflächen des metallischen Wärmeableitungselements durchdringt, auf dem metallischen Wärmeableitungselement angeordnet ist und ein Ende des dritten Verbindungsunterelements, das von dem zweiten Verbindungsunterelement entfernt ist, durch das zweite Durchgangsloch verläuft und durch das zweite Durchgangsloch fest mit dem metallischen Wärmeableitungselement verbunden ist.

9. Elektronische Vorrichtung nach Anspruch 8, wobei eine Art einer festen Verbindung zwischen dem dritten Verbindungsunterelement und dem metallischen Wärmeableitungselement eine von einer Presspassungsverbindung, einer Schnappverbindung oder einer Schweißverbindung ist.

10. Elektronische Vorrichtung nach einem der Ansprüche 3 bis 7, wobei die Erstreckungsrichtung des dritten Verbindungsunterelements parallel zu dem metallischen Wärmeableitungselement ist und das dritte Verbindungsunterelement an einer Oberfläche des metallischen Wärmeableitungselements, die der Grundplatte zugewandt ist, angebracht ist.

11. Elektronische Vorrichtung nach Anspruch 1, wobei die Leiterplatte eine Signalübertragungseinheit und eine Signalempfangseinheit umfasst, die Signalübertragungseinheit dazu konfiguriert ist, ein Signal zu übertragen, und die Signalempfangseinheit dazu konfiguriert ist, ein Signal zu empfangen.

12. Elektronische Vorrichtung nach Anspruch 1, wobei das elektrische Verbindungselement ein Fischaugenstift ist.

13. Endgerät, wobei das Endgerät die elektronische Vorrichtung nach einem der Ansprüche 1 bis 12 umfasst und die elektronische Vorrichtung an dem Endgerät befestigt ist.

14. Endgerät nach Anspruch 13, wobei das Endgerät ein Auto, ein unbemanntes Luftfahrzeug oder ein Roboter ist.

15. Radar, wobei das Radar die elektronische Vorrichtung nach einem der Ansprüche 1 bis 12 umfasst.

## Revendications

1. Appareil électronique, dans lequel l'appareil électronique comprend un boîtier (100), un élément de dissipation de chaleur métallique (200), un élément de connexion électrique (300) et une carte de circuit imprimé (400), l'élément de dissipation de chaleur métallique (200) et la carte de circuit imprimé (400) sont situés dans le boîtier (100), le boîtier (100) comprend une plaque de base (110), et l'élément de dissipation de chaleur métallique (200) est situé entre la plaque de base (110) et la carte de circuit imprimé (400) ; et la carte de circuit imprimé (400) comprend une couche de mise à la terre (410) et un dispositif électronique (420), une extrémité de l'élément de connexion électrique (300) est connectée électriquement à la couche de mise à la terre (410), et l'autre extrémité de l'élément de connexion électrique (300) est connectée électriquement à l'élément de dissipation de chaleur métallique (200), **caractérisé en ce que** l'élément de connexion électrique (300) est moulé d'un seul tenant dans le boîtier (100) par injection et est connecté de manière fixe au boîtier (100).

2. Appareil électronique selon la revendication 1, dans lequel l'élément de connexion électrique comprend un premier sous-élément de connexion, un deuxième sous-élément de connexion et un troisième sous-élément de connexion qui sont connectés séquentiellement, le deuxième sous-élément de connexion est connecté de manière fixe au boîtier, une extrémité du premier sous-élément de connexion et qui est éloignée du deuxième sous-élément de connexion est connectée électriquement à la couche de mise à la terre, et le troisième sous-élément de connexion est connecté électriquement à l'élément de dissipation de chaleur métallique.

3. Appareil électronique selon la revendication 2, dans lequel une direction d'extension du premier sous-élément de connexion croise la carte de circuit imprimé, un premier trou traversant est disposé sur la carte de circuit imprimé, et le premier sous-élément de connexion est inséré dans le premier trou traversant et est connecté au premier trou traversant, pour se connecter électriquement à la couche de mise à la terre.

4. Appareil électronique selon la revendication 2, dans lequel le boîtier comprend également une partie de fixation, la partie de fixation est configurée pour se connecter de manière fixe au deuxième sous-élément de connexion, et au moins une partie du deuxième sous-élément de connexion est située dans la partie de fixation.

5. Appareil électronique selon la revendication 4, dans lequel le boîtier comprend également un corps de boîtier, le corps de boîtier comprend une première paroi latérale, la partie de fixation est disposée sur un côté de la plaque de base et qui fait face à la carte de circuit imprimé, et la partie de fixation est disposée adjacente à la première paroi latérale.

6. Appareil électronique selon la revendication 5, dans lequel l'élément de dissipation de chaleur métallique comprend un premier bord latéral, le premier bord latéral est disposé de manière adjacente à la première paroi latérale, le premier bord latéral a une première encoche, une projection orthographique de la partie de fixation sur la plaque de base est située dans une projection orthographique de la première encoche sur la plaque de base, le premier sous-élément de connexion est connecté à la carte de circuit imprimé à travers la première encoche, et la partie de fixation bute contre la carte de circuit imprimé à travers la première encoche.

7. Appareil électronique selon la revendication 4, dans lequel un premier trou traversant qui pénètre dans deux surfaces opposées de l'élément de dissipation de chaleur métallique est disposé sur l'élément de dissipation de chaleur métallique, et la projection orthographique de la partie de fixation sur la plaque de base est située dans une projection orthographique du premier trou traversant sur la plaque de base.

8. Appareil électronique selon l'une quelconque des revendications 3 à 7, dans lequel une direction d'extension du troisième sous-élément de connexion croise l'élément de dissipation de chaleur métallique, un deuxième trou traversant qui pénètre dans les deux surfaces opposées de l'élément de dissipation de chaleur métallique est disposé sur l'élément de dissipation de chaleur métallique, et une extrémité du troisième sous-élément de connexion et qui est éloignée du deuxième sous-élément de connexion passe à travers le deuxième trou traversant et est reliée de manière fixe à l'élément de dissipation de chaleur métallique à travers le deuxième trou traversant.

9. Appareil électronique selon la revendication 8, dans lequel un mode de connexion fixe entre le troisième sous-élément de connexion et l'élément de dissipation de chaleur métallique est l'un des suivants : connexion à ajustement serré, connexion à encliquetage, ou soudage.

10. Appareil électronique selon l'une quelconque des revendications 3 à 7, dans lequel la direction d'extension du troisième sous-élément de connexion est parallèle à l'élément de dissipation de chaleur métallique, et le troisième sous-élément de connexion est fixé à une surface de l'élément de dissipation de chaleur métallique et fait face à la plaque de base.

11. Appareil électronique selon la revendication 1, dans lequel la carte de circuit imprimé comprend une unité de transmission de signal et une unité de réception de signal, l'unité de transmission de signal est configurée pour transmettre un signal, et l'unité de réception de signal est configurée pour recevoir un signal.

12. Appareil électronique selon la revendication 1, dans lequel l'élément de connexion électrique est une broche fisheye.

13. Dispositif terminal, dans lequel le dispositif terminal comprend l'appareil électronique selon l'une quelconque des revendications 1 à 12, et l'appareil électronique est fixé au dispositif terminal.

14. Dispositif terminal selon la revendication 13, dans lequel le dispositif terminal est une voiture, un véhicule aérien sans pilote ou un robot.

15. Radar, dans lequel le radar comprend l'appareil électronique selon l'une quelconque des revendications 1 à 12.
